# EUROPEAN PATENT APPLICATION

(11) **EP 4 716 431 A1**
(43) Date of publication of application: **25.03.2026**
(21) Application number: 24824982.3
(22) Date of filing: 11.04.2024
(51) Int. Cl.: H10K 30/81

(54) **SOLAR CELL AND PREPARATION METHOD THEREFOR, AND ELECTRIC DEVICE**

(30) Priority: 20.06.2023 CN 202310737462
(71) Applicant: Contemporary Amperex Future Energy Research Institute (Shanghai) Limited, Shanghai 200241 (CN); Contemporary Amperex Technology Co., Limited, Ningde City, Fujian 352100 (CN)
(72) Inventor: CHEN, Chen, Shanghai 201100 (CN); LI, Yaru, Shanghai 201100 (CN); CHEN, Junchao, Shanghai 201100 (CN); JIA, Boyu, Shanghai 201100 (CN); GU, Shuai, Shanghai 201100 (CN); QIAO, Hong, Shanghai 201100 (CN); MENG, Ke, Shanghai 201100 (CN); GUO, Yongsheng, Shanghai 201100 (CN); CHEN, Guodong, Shanghai 201100 (CN)
(74) Representative: Gong, Jinping
(86) International application number: PCT/CN2024/087312
(87) International publication number: WO 2024/260080

(57) **Abstract**

The present application provides a solar cell, a preparation method thereof, and an electric apparatus. The solar cell includes a substrate, a conductive layer, a grid line layer, a perovskite functional layer, and an electrode layer, where the conductive layer includes conductive portions with a first gap between the conductive portions, the grid line layer includes a plurality of grid lines, the perovskite functional layer includes functional portions with a second gap between the functional portions, each grid line is located between the first gap and the second gap that are adjacent to each other, the electrode layer includes a plurality of electrodes, and the electrodes are electrically connected to the grid lines.

## Description

The present application claims priority to Chinese Patent Application No. 202310737462.0, filed on June 20, 2023, entitled "SOLAR CELL, PREPARATION METHOD THEREOF, AND ELECTRIC APPARATUS," which is incorporated herein by reference in its entirety.

### TECHNICAL FIELD

The present application relates to the field of solar cell technology, and more particularly, to a solar cell, a preparation method thereof, and an electric apparatus.

### BACKGROUND

Perovskite solar cells refer to cells that use perovskite materials as the light-absorbing layer. Due to the significant performance advantages of perovskite materials, such as high light absorption coefficient, carrier mobility, and direct and tunable optical bandgap, perovskite solar cells have attracted widespread attention and developed rapidly. However, in existing perovskite solar cells, several sub-cells are formed within the solar cell by laser scribing. Additionally, channels are formed in the perovskite functional layer by laser scribing, and conductive materials are disposed within the channels to achieve series connection within the solar cell, resulting in a complex preparation process for perovskite solar cells.

Therefore, proposing a solar cell with a simple preparation process is an urgent problem to be solved.

### SUMMARY

Technical problem to be solved by the present application:

The present application is made in view of the above technical problems, with the objective of providing a solar cell with a simple preparation process, a preparation method thereof, and an electric apparatus.

Technical solution for solving the technical problem:

To achieve the above objective, the present application provides the solar cell, the preparation method thereof, and the electric apparatus.

According to a first aspect, the present application provides a solar cell, including: a substrate; a conductive layer disposed on the substrate, where the conductive layer includes a plurality of conductive portions, with a first gap between the conductive portions; a grid line layer disposed on the conductive layer, where the grid line layer includes a plurality of grid lines, and the grid lines are disposed on the conductive portions; a perovskite functional layer disposed on the conductive layer and the grid line layer, where the perovskite functional layer includes a plurality of functional portions, with a second gap between the functional portions, each functional portion is disposed on two adjacent conductive portions, and each grid line is located between the first gap and the second gap that are adjacent to each other; and an electrode layer disposed on the perovskite functional layer, where the electrode layer includes a plurality of electrodes, with the second gap between the electrodes, and the electrodes are electrically connected to the grid lines.

In the technical solution of the embodiments of the present application, by disposing a grid line layer between the conductive layer and the perovskite functional layer, where the conductive layer includes a plurality of conductive portions, the grid line layer includes a plurality of grid lines disposed on the conductive portions, the perovskite functional layer includes a plurality of functional portions, the electrode layer includes a plurality of electrodes, with a second gap between each functional portion and the electrode disposed thereon and an adjacent functional portion and the electrode disposed thereon, each functional portion is disposed on two adjacent conductive portions, and each grid line is located between the first gap and the second gap that are adjacent to each other, series connection within the solar cell is achieved through electrical connection between the electrodes and the grid lines. Additionally, the second gap between each functional portion and the electrode disposed thereon and an adjacent functional portion and the electrode disposed thereon allows for a single scribing step to penetrate the perovskite functional layer and the electrode layer during the preparation process, thereby simplifying the preparation process of the perovskite solar cell.

In some embodiments, the grid line includes a grid line body, where an end of the grid line body is provided with a first extension portion and/or a second extension portion, the functional portion covers the grid line body, the first extension portion and/or the second extension portion is exposed from the functional portion. The electrode includes a diffusion portion, where an end of the diffusion portion is provided with a first electrical connection portion and/or a second electrical connection portion, the diffusion portion is disposed on the functional portion, the first electrical connection portion is electrically connected to the first extension portion, and/or the second electrical connection portion is electrically connected to the second extension portion.

In the technical solution of the embodiments of the present application, exposing the first extension portion and/or the second extension portion from the functional portion facilitates electrical connection of the first extension portion to the first electrical connection portion and/or the second extension portion to the second electrical connection portion, achieving electrical connection between the grid line and the electrode.

In some embodiments, the substrate includes a first region, a second region, and a third region, where the second region is located between the first region and the third region, and the conductive layer is disposed in the second region.

In the technical solution of the embodiments of the present application, disposing the conductive layer in the second region, without the need to dispose the conductive layer in the first region and the third region, reduces the possibility of short-circuit problems between the conductive portions of the conductive layer in the first region and the third region, thereby increasing the stability of the solar cell.

In some embodiments, the first extension portion and the first electrical connection portion are located in the first region, the first extension portion is disposed on the substrate, and the first electrical connection portion is disposed on the first extension portion or disposed on the first extension portion and the substrate.

In the technical solution of the embodiments of the present application, by disposing the first extension portion on the substrate, the first extension portion and the first electrical connection portion are electrically connected, forming a current path in the solar cell.

In some embodiments, the second extension portion and the second electrical connection portion are located in the third region, the second extension portion is disposed on the substrate, and the second electrical connection portion is disposed on the second extension portion or disposed on the second extension portion and the substrate.

In the technical solution of the embodiments of the present application, by disposing the second extension portion on the substrate, the second extension portion and the second electrical connection portion are electrically connected, forming a current path in the solar cell.

In some embodiments, the substrate includes a first region, a second region, and a third region, where the second region is located between the first region and the third region, the conductive layer is disposed in the second region and further disposed in the first region and/or the third region, the conductive layer in the first region and the third region is insulated from the conductive layer in the second region, and the conductive layer in the first region and the third region includes a plurality of conductive branches, where the conductive branches correspond to the conductive portions, and the conductive branches are insulated from each other.

In the technical solution of the embodiments of the present application, the conductive layer is disposed in the second region and further disposed in the first region and/or the third region, and by insulating the conductive layer in the first region and the third region from the conductive layer in the second region, the process of stripping the conductive layer in the first region and the conductive layer in the second region is eliminated, saving production time and improving production efficiency.

In some embodiments, the first extension portion and the first electrical connection portion are located in the first region, the first extension portion is disposed on one of the conductive branches, and the first electrical connection portion is disposed on the first extension portion and/or the conductive branch where the first extension portion is located.

In the technical solution of the embodiments of the present application, by disposing the first extension portion on one of the conductive branches, where the conductive branch is insulated from the conductive layer in the second region and the conductive branches are insulated from each other, disposing the first electrical connection portion on the first extension portion and/or the conductive branch where the first extension portion is located prevents short-circuit phenomena, increasing the stability of the solar cell.

In some embodiments, the second extension portion and the second electrical connection portion are located in the third region, the second extension portion is disposed on one of the conductive branches, and the second electrical connection portion is disposed on the second extension portion and/or the conductive branch where the second extension portion is located.

In the technical solution of the embodiments of the present application, by disposing the second extension portion on one of the conductive branches, where the conductive branch is insulated from the conductive layer in the second region and the conductive branches are insulated from each other, disposing the second electrical connection portion on the second extension portion and/or the conductive branch where the second extension portion is located prevents short-circuit phenomena, increasing the stability of the solar cell.

In some embodiments, a thickness of the grid line is greater than or equal to 40 nm, optionally 40-80 nm.

In the technical solution of the embodiments of the present application, when the thickness of the grid line is within the above range, the solar cell has a higher photoelectric conversion rate.

According to a second aspect, the present application provides a preparation method of the solar cell, including:
providing the substrate;
disposing the conductive layer on the substrate, where the conductive layer includes the plurality of conductive portions, with the first gap between the conductive portions;
disposing the grid line layer on the conductive layer, where the grid line layer includes the plurality of grid lines, and the grid lines are disposed on the conductive portions;
disposing the perovskite functional layer on the conductive layer and the grid line layer;
disposing the electrode layer on the perovskite functional layer, and forming the second gap penetrating the electrode layer and the perovskite functional layer, where the perovskite functional layer includes the plurality of functional portions, with the second gap between the functional portions, each functional portion is disposed on two adjacent conductive portions, each grid line is located between the first gap and the second gap that are adjacent to each other, the electrode layer includes the plurality of electrodes, with the second gap between the electrodes, and the electrodes are electrically connected to the grid lines.

In the technical solution of the embodiments of the present application, the step of disposing the conductive layer on the substrate includes: performing a first scribing on a first prefabricated layer for forming the conductive layer to form the plurality of conductive portions, with the first gap between the conductive portions.

In the technical solution of the embodiments of the present application, by performing the first scribing on the first prefabricated layer for forming the conductive layer, a plurality of conductive portions are formed, with adjacent conductive portions isolated by the first gap.

In the technical solution of the embodiments of the present application, the steps of disposing the perovskite functional layer on the conductive layer and the grid line layer, disposing the electrode layer on the perovskite functional layer, and forming the second gap penetrating the electrode layer and the perovskite functional layer include: sequentially disposing a second prefabricated layer for forming the perovskite functional layer and a third prefabricated layer for forming the electrode layer on the conductive layer and the grid line layer, and performing a second scribing on the second prefabricated layer and the third prefabricated layer to form the second gap penetrating the third prefabricated layer and the second prefabricated layer.

In the technical solution of the embodiments of the present application, by performing the second scribing on the second prefabricated layer for forming the perovskite functional layer and the third prefabricated layer for forming the electrode layer, the second gap penetrating the third prefabricated layer and the second prefabricated layer is formed, allowing for a single scribing step to penetrate the perovskite functional layer and the electrode layer during the preparation process, thereby simplifying the preparation process of the solar cell.

In the technical solution of the embodiments of the present application, the first gap allows the conductive layer to form the plurality of sequentially isolated conductive portions, while the grid lines are disposed on the conductive portions, and the grid lines are electrically connected to the electrodes, forming a current path in the solar cell to achieve conversion of light energy to electrical energy. The grid lines do not contact the perovskite layer, thereby increasing the stability of the solar cell.

According to a third aspect, the present application provides an electric apparatus, including the solar cell as described above or a solar cell prepared by the preparation method of the solar cell as described above.

### BRIEF DESCRIPTION OF DRAWINGS

FIG. 1 is a top view of a partial structure of a solar cell according to some embodiments of the present application.
FIG. 2 is a cross-sectional view of a partial structure of a solar cell according to some embodiments of the present application.
FIG. 3 is a top view of a partial structure of a solar cell according to some embodiments of the present application.
FIG. 4 is a top view of a partial structure of a solar cell according to some other embodiments of the present application.
FIG. 5 is a cross-sectional view of a partial structure of a solar cell according to some embodiments of the present application.
FIG. 6 is a top view of a partial structure of a solar cell according to some embodiments of the present application.
FIG. 7 is a cross-sectional view of a partial structure of a solar cell according to some embodiments of the present application.
FIG. 8 is a top view of an overall structure of a solar cell according to some embodiments of the present application.
FIG. 9 is a cross-sectional view of an overall structure of a solar cell according to some embodiments of the present application.
FIG. 10 is a schematic diagram of a structure of an electric apparatus according to some embodiments of the present application.

In the drawings, the drawings are not drawn to actual scale.

Description of reference signs: 100. solar cell; 10. substrate; 11. first region; 12. second region; 13. third region; 20. conductive layer; 21. conductive portion; 22. conductive branch; 221. first part; 222. second part; 21a. first gap; 22a. third gap; 30. grid line layer; 31. grid line; 311. first extension portion; 312. grid line body; 313. second extension portion; 40. perovskite functional layer; 41. functional portion; 41a. second gap; 42. hole transport layer; 43. perovskite layer; 44. electron transport layer; 50. electrode layer; 51. electrode; 511. first electrical connection portion; 512. diffusion portion; 513. second electrical connection portion; and 1000. electric apparatus.

### DESCRIPTION OF EMBODIMENTS

Hereinafter, embodiments specifically disclosing a solar cell, a preparation method thereof, and an electric apparatus of the present application will be described in detail with appropriate reference to the drawings. However, there may be cases where unnecessary detailed descriptions are omitted. For example, detailed descriptions of well-known matters or repetitive descriptions of substantially identical structures may be omitted. This is to avoid unnecessarily lengthy descriptions and to facilitate understanding by those skilled in the art. Additionally, the drawings and the following descriptions are provided to enable those skilled in the art to fully understand the present application and are not intended to limit the subject matter recited in the claims.

"Ranges" disclosed in the present application are defined in the form of lower and upper limits. A given range is defined by selecting one lower limit and one upper limit, where the selected lower and upper limits define the boundaries of that specific range. Ranges defined in this manner may include or exclude the endpoints and can be arbitrarily combined, meaning that any lower limit can be combined with any upper limit to form a range. For example, if ranges of 60-120 and 80-110 are provided for a specific parameter, it is understood that ranges of 60-110 and 80-120 can also be envisioned. Additionally, if minimum range values of 1 and 2 are listed, and maximum range values of 3, 4, and 5 are listed, the following ranges can all be anticipated: 1-3, 1-4, 1-5, 2-3, 2-4, and 2-5. In the present application, unless otherwise stated, a value range of "a-b" is a short representation of any combination of real numbers between a and b, where both a and b are real numbers. For example, a value range of "0-5" means that all real numbers in the range of "0-5" are listed herein, and "0-5" is a short representation of a combination of these values. Additionally, when a parameter is expressed as an integer ≥ 2, it is equivalent to disclosing that the parameter is, for example, an integer of 2, 3, 4, 5, 6, 7, 8, 9, 10, 11, or 12

Unless otherwise specified, all embodiments and optional embodiments of the present application may be combined with each other to form new technical solutions.

Unless otherwise specified, all technical features and optional technical features of the present application can be combined with each other to form new technical solutions.

Unless otherwise specified, all steps of the present application may be performed sequentially or randomly, preferably sequentially. For example, a method including steps (a) and (b) indicates that the method may include steps (a) and (b) performed sequentially, or steps (b) and (a) performed sequentially. For example, mentioning that the method may further include step (c) indicates that step (c) may be added to the method in any order. For example, the method may include steps (a), (b), and (c), or steps (a), (c), and (b), or steps (c), (a), and (b), or the like.

Unless otherwise specified, "include" and "comprise" mentioned in the present application indicate an open-ended or closed-ended scope. For example, "include" and "comprise" may indicate that other components not listed may also be included or comprised, or only the listed components may be included or comprised.

Unless otherwise specified, the term "or" in the present application is inclusive. For example, the phrase "A or B" means "A, B, or both A and B." More specifically, any one of the following conditions satisfies the condition "A or B": A is true (or present) and B is false (or not present); A is false (or not present) and B is true (or present); or both A and B are true (or present).

Currently, with the development of market trends, the application of perovskite solar cells is becoming increasingly widespread. Perovskite solar cells may be used in lunar rovers, satellite solar panels, various sensors, detectors, and civilian products such as wearable electronic products and automotive power supplies, making perovskite solar cells a power source for consumer products in many aspects. With the continuous expansion of application fields for perovskite solar cells and their flexible foldability, market demand is also continuously increasing.

In perovskite solar cells in the related art, a perovskite functional layer is typically formed on a conductive layer, and channels are formed in the perovskite functional layer by laser scribing, where the channels penetrate the perovskite functional layer in the thickness direction. An electrode layer is formed by disposing conductive material on the perovskite functional layer, and the conductive material is simultaneously disposed within the channels to achieve electrical connection between the conductive layer and the electrode layer. Subsequently, the electrode layer and the perovskite functional layer are scribed for each perovskite solar module to form several sub-cells. Since scribing the perovskite functional layer alone and scribing the electrode layer and the perovskite functional layer are two separate steps, the preparation process for perovskite solar cells is complex.

To solve the above technical problems, the present application relates to a solar cell including a substrate, a conductive layer, a grid line layer, a perovskite functional layer, and an electrode layer. The conductive layer is disposed on the substrate, where the conductive layer includes a plurality of conductive portions, with a first gap between the conductive portions; the grid line layer is disposed on the conductive layer, where the grid line layer includes a plurality of grid lines, and the grid lines are disposed on the conductive portions; the perovskite functional layer is disposed on the conductive layer and the grid line layer, where the perovskite functional layer includes a plurality of functional portions, with a second gap between the functional portions, each functional portion is disposed on two adjacent conductive portions, and each grid line is located between the first gap and the second gap that are adjacent to each other; and the electrode layer is disposed on the perovskite functional layer, where the electrode layer includes a plurality of electrodes, with the second gap between the electrodes, and the electrodes are electrically connected to the grid lines.

By disposing a grid line layer between the conductive layer and the perovskite functional layer, where the conductive layer includes a plurality of conductive portions, the grid line layer includes a plurality of grid lines disposed on the conductive portions, the perovskite functional layer includes a plurality of functional portions, the electrode layer includes a plurality of electrodes, with a second gap between each functional portion and the electrode disposed thereon and an adjacent functional portion and the electrode disposed thereon, each functional portion is disposed on two adjacent conductive portions, and each grid line is located between the first gap and the second gap that are adjacent to each other, series connection within the solar cell is achieved through electrical connection between the electrodes and the grid lines. Additionally, the second gap between each functional portion and the electrode disposed thereon and an adjacent functional portion and the electrode disposed thereon allows for a single scribing step to penetrate the perovskite functional layer and the electrode layer during the preparation process, thereby simplifying the preparation process of the perovskite solar cell.

Furthermore, in the related art as described above, forming channels in the perovskite functional layer by laser scribing has several drawbacks. For example, if the laser scribing energy is too low, residual perovskite functional layer material remains in the channel, and if the laser scribing energy is too high, it damages the conductive layer. Thus, whether the laser scribing energy is too high or too low, it increases the series resistance of the perovskite solar cell, easily leading to poor stability of the perovskite solar cell.

In the present application, since the step of scribing the perovskite functional layer alone is eliminated, the problem of increased series resistance in the solar cell caused by this step is avoided, thereby improving the stability of the solar cell.

The solar cell disclosed in the embodiments of the present application can be used in electric apparatuses applying photoelectric conversion. The electric apparatus may include, but is not limited to, mobile phones, tablets, laptops, electric toys, electric tools, battery vehicles, electric vehicles, ships, spacecraft, and detectors. The electric toys may include fixed or mobile electric toys, such as game consoles, electric car toys, electric ship toys, and electric airplane toys, and the spacecraft may include airplanes, rockets, space shuttles, spaceships, and the like.

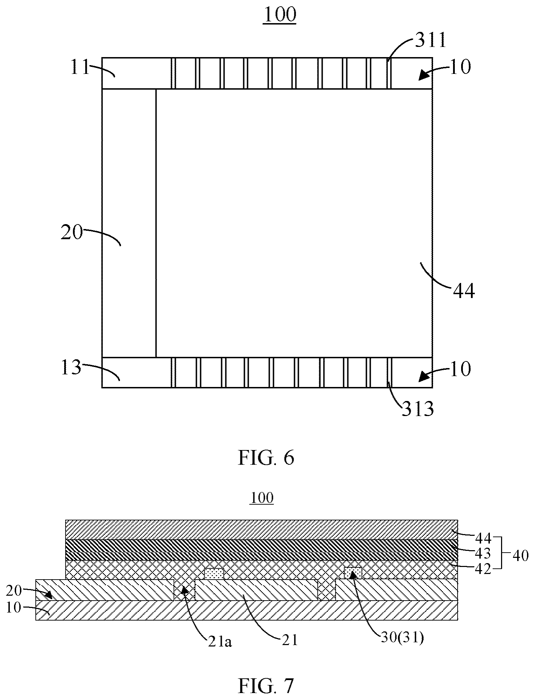

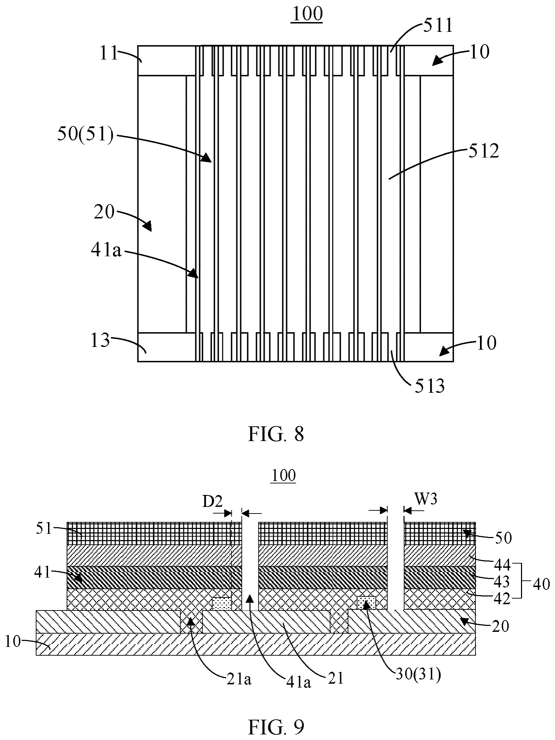

Referring to FIG. 7 and FIG. 8, according to some embodiments of the present application, the present application provides a solar cell 100, including:
a substrate 10;
a conductive layer 20 disposed on the substrate 10, where the conductive layer 20 includes a plurality of conductive portions 21, with a first gap 21a between the conductive portions 21;
a grid line layer 30 disposed on the conductive layer 20, where the grid line layer 30 includes a plurality of grid lines 31, and the grid lines 31 are disposed on the conductive portions 21;
a perovskite functional layer 40 disposed on the conductive layer 20 and the grid line layer 30, where the perovskite functional layer 40 includes a plurality of functional portions 41, with a second gap 41a between the functional portions 41, each functional portion 41 is disposed on two adjacent conductive portions 21, and each grid line 31 is located between the first gap 21a and the second gap 41a that are adjacent to each other; and
an electrode layer 50 disposed on the perovskite functional layer 40, where the electrode layer 50 includes a plurality of electrodes 51, with the second gap 41a between the electrodes 51, and the electrodes 51 are electrically connected to the grid lines 31.

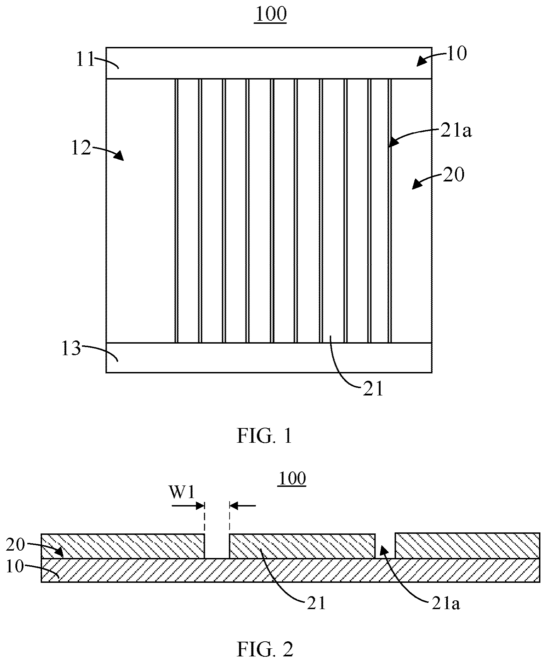

Referring to FIG. 1 and FIG. 2, the substrate 10 has various types and can be adapted to devices with different requirements. The substrate 10 includes, but is not limited to, at least one of a polyethylene terephthalate (polyethylene terephthalate, PET) substrate, a polyetherimide (Polyetherimide, PEI) substrate, a suede silicon substrate, a glass substrate, and a mica substrate. The PET substrate, PEI substrate, suede silicon substrate, glass substrate, and mica substrate have high light transmittance, allowing more sunlight to enter the perovskite functional layer 40, thereby improving the photoelectric conversion efficiency of the solar cell 100. The glass substrate includes at least one of tempered glass, float glass, and anti-reflective glass; and the mica substrate includes, but is not limited to, a muscovite substrate, where the muscovite substrate has extremely high light transmittance, as well as high flexibility and thermal stability.

The conductive layer 20 is a transparent conductive layer with high light transmittance, which is beneficial to improving the photoelectric conversion efficiency of the solar cell. The conductive layer 20 may be fluorine-doped tin oxide (FTO), where FTO has good visible light transmittance, a high ultraviolet absorption coefficient, low resistivity, stable chemical properties, and strong acid and alkali resistance. Certainly, the conductive layer 20 may be indium tin oxide (ITO), where ITO has high light transmittance and good electrical conductivity.

During the preparation process, the conductive layer 20 may be disposed on the substrate 10, and the first gap 21a is formed by a scribing process. Adjacent conductive portions 21 are isolated by the first gap 21a.

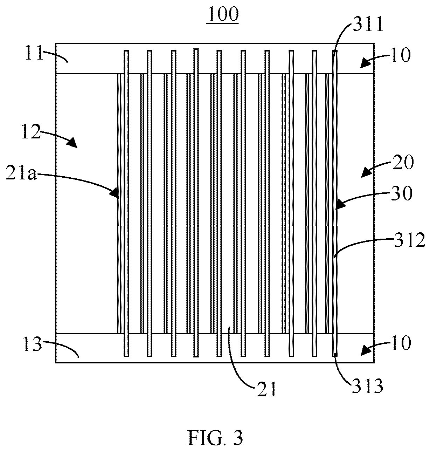

Referring to FIG. 3 to FIG. 5, the grid line layer 30 may be a metal layer including metals such as copper, gold, silver, and their alloys. The grid line layer 30 may be disposed on the conductive layer 20 by methods such as evaporation, sputtering, deposition, electroplating, or printing, but is not limited thereto.

Referring to FIG. 6 and FIG. 7, the perovskite functional layer 40 may include an electron transport layer 44, a hole transport layer 42, and a perovskite layer 43. The solar cell 100 may be a regular solar cell 100 or an inverted solar cell 100. In a regular solar cell 100, the electron transport layer 44, the perovskite layer 43, and the hole transport layer 42 are sequentially stacked in the direction from the conductive layer 20 to the electrode layer 50. In the inverted solar cell 100, the hole transport layer 42, the perovskite layer 43, and the electron transport layer 44 are sequentially stacked in the direction from the conductive layer 20 to the electrode layer 50. The embodiments of the present application are described with an inverted solar cell 100 as an example.

The hole transport layer 42 serves to transport holes and block electrons, and the electron transport layer 44 serves to transport electrons and block electron-hole recombination. The hole transport layer 42 and the electron transport layer 44 enable the solar cell 100 to have higher photoelectric conversion efficiency.

Referring to FIG. 8 and FIG. 9, the electrode layer 50 may be made of a metal material or a transparent conductive material. The metal material may be metals such as copper, gold, silver, and their alloys. The transparent conductive material may be indium tin oxide, fluorine-doped tin oxide, or aluminum-doped zinc oxide.

When sunlight irradiates the perovskite layer 43, the sunlight photons are absorbed by the perovskite layer 43, and the perovskite layer 43 absorbs photons to generate "electron-hole pairs." The built-in electric field due to the energy level difference between the hole transport layer 42, the perovskite layer 43, and the electron transport layer 44 accelerates the transport of electrons and holes. That is, under the action of the built-in electric field, electrons and holes separate and transition. Holes transition to the hole transport layer 42 and are transported by the hole transport layer 42 to the conductive layer 20, where most holes accumulate in the conductive layer 20. The direction of electron transport is opposite to that of hole transport, with electrons transported to the electron transport layer 44 and by the electron transport layer 44 to the electrode layer 50, where most electrons accumulate in the electrode layer 50. Through electrical connection between the electrode 51 and the grid line 31, the conductive layer 20 and the electrode layer 50 are electrically connected, forming directional movement of charges, thereby generating current and achieving conversion of light energy to electrical energy.

By disposing a grid line layer 30 between the conductive layer 20 and the perovskite functional layer 40, where the conductive layer 20 includes a plurality of conductive portions 21, the grid line layer 30 includes a plurality of grid lines 31 disposed on the conductive portions 21, the perovskite functional layer 40 includes a plurality of functional portions 41, the electrode layer 50 includes a plurality of electrodes 51, with a second gap 41a between each functional portion 41 and the electrode 51 disposed thereon and an adjacent functional portion 41 and the electrode 51 disposed thereon, each functional portion 41 is disposed on two adjacent conductive portions 21, and each grid line 31 is located between the first gap 21a and the second gap 41a that are adjacent to each other, series connection within the solar cell 100 is achieved through electrical connection between the electrodes 51 and the grid lines 31. Additionally, the second gap 41a between each functional portion 41 and the electrode 51 disposed thereon and an adjacent functional portion 41 and the electrode 51 disposed thereon allows for a single scribing step to penetrate the perovskite functional layer 40 and the electrode layer 50 during the preparation process, thereby simplifying the preparation process of the solar cell 100.

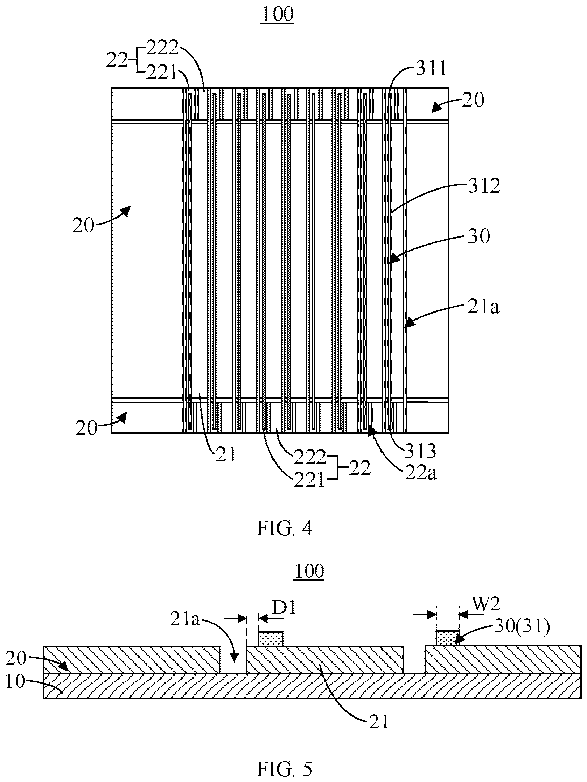

In some embodiments, still referring to FIG. 5, a distance D1 between the grid line 31 and the adjacent first gap 21a is 5-20 µm.

The distance D1 between the grid line 31 and the adjacent first gap 21a may be 5 µm, 5.4 µm, 5.8 µm, 6 µm, 6.5 µm, 6.8 µm, 7 µm, 7.4 µm, 7.8 µm, 8 µm, 8.4 µm, 8.6 µm, 9 µm, 9.3 µm, 9.8 µm, 10 µm, 10.2 µm, 10.6 µm, 11 µm, 11.4 µm, 11.6 µm, 12 µm, 12.3 µm, 12.8 µm, 13 µm, 13.4 µm, 13.9 µm, 14.5 µm, 14.8 µm, 15 µm, 15.5 µm, 16 µm, 16.5 µm, 16.7 µm, 16.9 µm, 17 µm, 17.5 µm, 18 µm, 18.5 µm, 19 µm, 19.5 µm, 20 µm, or fall into a range composed of any two of these values, such as 5-7 µm, 8-12 µm, 12.8-15 µm, 16-17.5 µm, or 18-20 µm, and is selected according to actual needs, as long as the distance D1 between the grid line 31 and the adjacent first gap 21a is within the range of 5-20 µm.

In some embodiments, still referring to FIG. 9, a distance D2 between the grid line 31 and the adjacent second gap 41a is 5-20 µm.

The distance D2 between the grid line 31 and the adjacent second gap 41a may be 5 µm, 5.5 µm, 5.7 µm, 6 µm, 6.4 µm, 6.8 µm, 7 µm, 7.5 µm, 7.8 µm, 8 µm, 8.6 µm, 8.9 µm, 9 µm, 9.2 µm, 9.6 µm, 10 µm, 10.5 µm, 10.8 µm, 11 µm, 11.4 µm, 11.6 µm, 12 µm, 12.5 µm, 12.8 µm, 13 µm, 13.6 µm, 13.9 µm, 14 µm, 14.5 µm, 15 µm, 15.5 µm, 16 µm, 16.5 µm, 16.7 µm, 17 µm, 17.4 µm, 17.7 µm, 18 µm, 18.5 µm, 19 µm, 19.5 µm, 20 µm, or fall into a range composed of any two of these values, such as 5-7.5 µm, 9-10.8 µm, 11-13.6 µm, 14-16.5 µm, 17-18.5 µm, or 19-20 µm, and is selected according to actual needs, as long as the distance D2 between the grid line 31 and the adjacent second gap 41a is within the range of 5-20 µm.

In some embodiments, still referring to FIG. 2, a width W1 of the first gap 21a is 20-200 µm.

In the technical solution of the embodiments of the present application, the width W 1 of the first gap 21a may be 20 µm, 25 µm, 30 µm, 35 µm, 40 µm, 45 µm, 50 µm, 56 µm, 60 µm, 66 µm, 70 µm, 73 µm, 78 µm, 80 µm, 85 µm, 88 µm, 90 µm, 96 µm, 98 µm, 100 µm, 105 µm, 110 µm, 116 µm, 120 µm, 127 µm, 130 µm, 135 µm, 140 µm, 146 µm, 150 µm, 154 µm, 160 µm, 166 µm, 170 µm, 175 µm, 180 µm, 185 µm, 190 µm, 196 µm, or 200 µm, or fall into a range composed of any two of these values, such as 20-50 µm, 60-90 µm, 96-110 µm, 120-140 µm, 146-170 µm, or 180-200 µm, and is selected according to actual needs, as long as the width W1 of the first gap 21a is within the range of 20-200 µm.

In the technical solution of the embodiments of the present application, when the width W 1 of the first gap 21a is within the above range, the solar cell 100 has better stability and cost-effectiveness.

Additionally, if the width W1 of the first gap 21a is less than 20 µm, the width below 20 µm results in insufficient isolation between adjacent conductive portions 21, which may lead to direct connection between adjacent conductive portions 21 during the use of the solar cell 100, affecting the stability of the solar cell 100. If the width W1 of the first gap 21a is greater than 200 µm, excessive stripping of the conductive layer 20 of the solar cell 100 leads to waste. Therefore, when the width W1 of the first gap 21a is within the above range, the solar cell 100 has better stability and cost-effectiveness.

In some embodiments, referring to FIG. 5, a width W2 of the grid line 31 is 50-200 µm.

The width W2 of the grid line 31 may be 50 µm, 53 µm, 55 µm, 60 µm, 65 µm, 68 µm, 70 µm, 75 µm, 80 µm, 85 µm, 88 µm, 90 µm, 95 µm, 97 µm, 100 µm, 106 µm, 108 µm, 110 µm, 115 µm, 120 µm, 125 µm, 130 µm, 135 µm, 138 µm, 140 µm, 143 µm, 146 µm, 150 µm, 154 µm, 160 µm, 166 µm, 170 µm, 175 µm, 180 µm, 185 µm, 190 µm, 196 µm, or 200 µm, or fall into a range composed of any two of these values, such as 50-75 µm, 90-110 µm, 115-130 µm, 140-166 µm, 170-185 µm, or 190-200 µm, and is selected according to actual needs, as long as the width W2 of the grid line 31 is within the range of 50-200 µm.

In the technical solution of the embodiments of the present application, when the width W2 of the grid line 31 is within the above range, the solar cell 100 has higher photoelectric conversion efficiency.

Additionally, if the width W2 of the grid line 31 is less than 50 µm, the width below 50 µm increases the resistance of the grid line 31, affecting the photoelectric conversion efficiency of the solar cell 100 and reducing the performance of the solar cell 100. If the width W2 of the grid line 31 is greater than 200 µm, the area of the grid line 31 covered by the perovskite functional layer 40 is too large, reducing the light-receiving area of the perovskite functional layer 40, thereby reducing the photoelectric conversion efficiency of the solar cell 100. Therefore, when the width W2 of the grid line 31 is within the above range, the solar cell 100 can have higher photoelectric conversion efficiency.

In some embodiments, still referring to FIG. 9, a width W3 of the second gap 41a is 50-200 µm.

The width W3 of the second gap 41a may be 50 µm, 56 µm, 58 µm, 60 µm, 65 µm, 67 µm, 70 µm, 74 µm, 80 µm, 86 µm, 88 µm, 90 µm, 94 µm, 97 µm, 100 µm, 105 µm, 107 µm, 110 µm, 114 µm, 118 µm, 120 µm, 123 µm, 127 µm, 130 µm, 136 µm, 138 µm, 140 µm, 145 µm, 148 µm, 150 µm, 155 µm, 160 µm, 166 µm, 170 µm, 176 µm, 180 µm, 185 µm, 190 µm, 196 µm, 200 µm, or fall into a range composed of any two of these values, such as 50-70 µm, 80-100 µm, 105-120 µm, 130-145 µm, 150-166 µm, 170-185 µm, or 190-200 µm, and is selected according to actual needs, as long as the width W3 of the second gap 41a is within the range of 50-200 µm.

In the technical solution of the embodiments of the present application, when the width W3 of the second gap 41a is 50-200 µm, the stability and photoelectric conversion efficiency of the solar cell 100 are improved.

Additionally, if the width W3 of the second gap 41a is less than 50 µm, the solar cell 100 may have a risk of short-circuiting, affecting the performance of the solar cell 100. If the width W3 of the second gap 41a is greater than 200 µm, the proportion of the effective photoelectric conversion area decreases, leading to low photoelectric conversion efficiency. Therefore, when the width W3 of the second gap 41a is within the above range, the performance of the solar cell 100 is more stable and has good photoelectric conversion efficiency.

In the technical solution of the embodiments of the present application, the first gap 21a allows the conductive layer 20 to form the plurality of sequentially isolated conductive portions 21, while the grid lines 31 are disposed on the conductive portions 21, and the second gap 41a penetrates the hole transport layer 42, the perovskite layer 43, the electron transport layer 44, and the electrode layer 50. The second gap 41a divides the solar cell 100 into a plurality of sub-cells, and the grid lines 31 are electrically connected to the electrodes 51, forming a current path. That is, during the preparation process, a single scribing step may be used to penetrate the perovskite functional layer and the electrode layer, thereby simplifying the preparation process of the perovskite solar cell.

In some embodiments, the grid line 31 includes a grid line body 312, where an end of the grid line body 312 is provided with a first extension portion 311 and/or a second extension portion 313, the functional portion 41 covers the grid line body 312, the first extension portion 311 and/or the second extension portion 313 is exposed from the functional portion 41. The electrode 51 includes a diffusion portion 512, where an end of the diffusion portion 512 is provided with a first electrical connection portion 511 and/or a second electrical connection portion 513, the diffusion portion 512 is disposed on the functional portion 41, the first electrical connection portion 511 is electrically connected to the first extension portion 311, and/or the second electrical connection portion 513 is electrically connected to the second extension portion 313.

In the technical solution of the embodiments of the present application, in the extension direction of the grid line 31, the length of the grid line 31 is at least greater than the length of the functional portion 41, so that the first extension portion 311 and/or the second extension portion 313 of the grid line 31 is exposed from the functional portion 41. The length of the electrode 51 may also be greater than the length of the functional portion 41, thereby facilitating electrical connection of the first electrical connection portion 511 to the first extension portion 311 and/or the second electrical connection portion 513 to the second extension portion 313.

In the extension direction of the grid line 31, the length of the substrate 10 may also be at least greater than the length of the functional portion 41 and greater than or equal to the length of the grid line 31, so that the first extension portion 311 and the second extension portion 313 are not only exposed from the functional portion 41 but also can be disposed on the substrate 10. The substrate 10 supports the first extension portion 311 and the second extension portion 313, thereby mitigating damage to the first extension portion 311 and the second extension portion 313 due to external forces, thus increasing the stability of the solar cell 100.

In the direction from the substrate 10 to the electrode layer 50, the grid line 31 is located between the conductive layer 20 and the hole transport layer 42, and the thickness of the grid line 31 is less than the thickness of the hole transport layer 42, so that the grid line body 312 can be completely covered by the hole transport layer 42, and the grid line 31 does not contact the perovskite layer 43, mitigating potential damage to the perovskite layer 43 by the grid line 31, thus increasing the stability and extending the service life of the solar cell 100.

In the technical solution of the embodiments of the present application, exposing the first extension portion 311 and/or the second extension portion 313 from the functional portion 41 facilitates electrical connection of the first extension portion 311 to the first electrical connection portion 511 and/or the second extension portion 313 to the second electrical connection portion 513, achieving electrical connection between the grid line 31 and the electrode 51.

In some embodiments, the substrate 10 includes a first region 11, a second region 12, and a third region 13, where the second region 12 is located between the first region 11 and the third region 13, and the conductive layer 20 is disposed in the second region 12.

The first region 11, the second region 12, and the third region 13 may be sequentially connected in the extension direction of the grid line 31. The conductive layer 20 is disposed in the second region 12, the grid line body 312 is disposed on the conductive layer 20, and the perovskite functional layer 40 is disposed on the conductive layer 20 and the grid line body 312. The perovskite functional layer 40 may be located in the second region 12. The perovskite functional layer 40 covers the grid line body 312 and the side of the conductive layer 20 facing the grid line body 312.

In the technical solution of the embodiments of the present application, disposing the conductive layer 20 in the second region 12, without the need to dispose the conductive layer 20 in the first region 11 and the third region 13, reduces the possibility of short-circuit problems between the conductive portions 21 of the conductive layer 20 in the first region 11 and the third region 13, thereby increasing the stability of the solar cell 100.

In some embodiments, the first extension portion 311 and the first electrical connection portion 511 are located in the first region 11, the first extension portion 311 is disposed on the substrate 10, and the first electrical connection portion 511 is disposed on the first extension portion 311 or disposed on the first extension portion 311 and the substrate 10.

The first extension portion 311 and the first electrical connection portion 511 are located in the first region 11. The first extension portion 311 is exposed from the perovskite functional layer 40 and disposed on the substrate 10, the diffusion portion 512 of the electrode 51 is disposed on the perovskite functional layer 40, and the first electrical connection portion 511 may extend from the diffusion portion 512 toward the substrate 10, thereby electrically connecting to the first extension portion 311, forming a current path in the solar cell 100.

In some embodiments, the second extension portion 313 and the second electrical connection portion 513 are located in the third region 13, the second extension portion 313 is disposed on the substrate 10, and the second electrical connection portion 513 is disposed on the second extension portion 313 or disposed on the second extension portion 313 and the substrate 10.

The second extension portion 313 and the second electrical connection portion 513 are located in the third region 13. The second extension portion 313 is exposed from the perovskite functional layer 40 and disposed on the substrate 10, the diffusion portion 512 of the electrode 51 is disposed on the perovskite functional layer 40, and the second electrical connection portion 513 may extend from the diffusion portion 512 toward the substrate 10, thereby electrically connecting to the second extension portion 313, forming a current path in the solar cell 100.

In some embodiments, in the solar cell 100, an end of the grid line 31 may be provided with only the first extension portion 311 and without the second extension portion 313, and an end of the electrode 51 may be provided with only the first electrical connection portion 511 and without the second electrical connection portion 513. The first extension portion 311 and the first electrical connection portion 511 are electrically connected, achieving a current path within the solar cell 100.

In some embodiments, in the solar cell 100, an end of the grid line 31 may be provided with only the second extension portion 313 and without the first extension portion 311, and an end of the electrode 51 may be provided with only the second electrical connection portion 513 and without the first electrical connection portion 511. The second extension portion 313 and the second electrical connection portion 513 are electrically connected, achieving a current path within the solar cell 100.

In some embodiments, in the solar cell 100, an end of the grid line 31 may be provided with both the first extension portion 311 and the second extension portion 313, and an end of the electrode 51 may be provided with both the first electrical connection portion 511 and the second electrical connection portion 513. The first extension portion 311 is electrically connected to the first electrical connection portion 511, and the second extension portion 313 is electrically connected to the second electrical connection portion 513, achieving a current path within the solar cell 100.

In some embodiments, the substrate 10 includes a first region 11, a second region 12, and a third region 13, where the second region 12 is located between the first region 11 and the third region 13, the conductive layer 20 is disposed in the second region 12 and further disposed in the first region 11 and/or the third region 13, the conductive layer 20 in the first region 11 and the third region 13 is insulated from the conductive layer 20 in the second region 12, and the conductive layer 20 in the first region 11 and the third region 13 includes a plurality of conductive branches 22, where the conductive branches 22 correspond to the conductive portions 21, and the conductive branches 22 are insulated from each other.

Optionally, the conductive layer 20 is disposed in the second region 12 and the first region 11, and the conductive layer 20 in the first region 11 is insulated from the conductive layer 20 in the second region 12.

Optionally, the conductive layer 20 is disposed in the second region 12 and the third region 13, and the conductive layer 20 in the third region 13 is insulated from the conductive layer 20 in the second region 12.

Optionally, the conductive layer 20 is disposed in the first region 11, the second region 12, and the third region 13, the conductive layer 20 in the first region 11 is insulated from the conductive layer 20 in the second region 12, and the conductive layer 20 in the third region 13 is also insulated from the conductive layer 20 in the second region 12.

During the preparation process, the conductive layer 20 in the first region 11 and the third region 13 may be insulated from the conductive layer 20 in the second region 12 by methods such as laser scribing, etching, or cutting with a cutting machine, thereby eliminating the process of stripping the conductive layer 20 in the first region 11 and the conductive layer 20 in the second region 12, saving production time and improving production efficiency.

The conductive layer 20 in the first region 11 and the third region 13 includes a plurality of conductive branches 22, where the conductive branches 22 correspond to the conductive portions 21, and the conductive branches 22 are insulated from each other. Since the conductive layer 20 in the first region 11 and the third region 13 is insulated from the conductive layer 20 in the second region 12, the conductive branches 22 are insulated from the conductive layer 20 in the second region 12.

The first gap 21a between the conductive portions 21 extends from an edge of the first region 11 away from the second region 12 to an edge of the third region 13 away from the second region 12.

The conductive branch 22 includes a first part 221 and a second part 222. The first extension portion 311 and the second extension portion 313 of the grid line 31 are located in the first part 221. A third gap 22a is provided between the first part 221 and the second part 222. The third gap 22a is located between the first gap 21a and the second gap 41a that are adjacent to each other, and the adjacent first gap 21a and third gap 22a are located between two adjacent second gaps 41a. In the adjacent first gap 21a and third gap 22a, the third gap 22a in the first region 11 and the third gap 22a in the third region 13 are located on the same side of the first gap 21a. The first part 221 is located between the adjacent third gap 22a and first gap 21a. Certainly, the third gap 22a may be alternatively omitted, as long as the conductive layer 20 in the first region 11 and the third region 13 is insulated from the conductive layer 20 in the second region 12, and adjacent conductive branches 22 are insulated from each other.

In the technical solution of the embodiments of the present application, the conductive layer 20 is disposed in the second region 12 and further disposed in the first region 11 and/or the third region 13, and by insulating the conductive layer 20 in the first region 11 and the third region 13 from the conductive layer 20 in the second region 12, the process of stripping the conductive layer 20 in the first region 11 and the conductive layer 20 in the second region 12 is eliminated, saving production time and improving production efficiency.

In some embodiments, the first extension portion 311 and the first electrical connection portion 511 are located in the first region 11, the first extension portion 311 is disposed on one of the conductive branches 22, and the first electrical connection portion 511 is disposed on the first extension portion 311 and/or the conductive branch 22 where the first extension portion 311 is located.

In the technical solution of the embodiments of the present application, by disposing the first extension portion 311 on one of the conductive branches 22, where the conductive branch 22 is insulated from the conductive layer 20 in the second region 12 and the conductive branches 22 are insulated from each other, disposing the first electrical connection portion 511 on the first extension portion 311 and/or the conductive branch 22 where the first extension portion 311 is located prevents short-circuit phenomena, increasing the stability of the solar cell 100.

In some embodiments, the second extension portion 313 and the second electrical connection portion 513 are located in the third region 13, the second extension portion 313 is disposed on one of the conductive branches 22, and the second electrical connection portion 513 is disposed on the second extension portion 313 and/or the conductive branch 22 where the second extension portion 313 is located.

In the technical solution of the embodiments of the present application, by disposing the second extension portion 313 on one of the conductive branches 22, where the conductive branch 22 is insulated from the conductive layer 20 in the second region 12 and the conductive branches 22 are insulated from each other, disposing the second electrical connection portion 513 on the second extension portion 313 and/or the conductive branch 22 where the second extension portion 313 is located prevents short-circuit phenomena, increasing the stability of the solar cell 100.

In some embodiments, a thickness of the grid line 31 is greater than or equal to 40 nm, optionally 40-300 nm.

The thickness of the grid line 31 may be 40 nm, 42 nm, 44 nm, 45 nm, 46 nm, 48 nm, 49 nm, 50 nm, 51 nm, 53 nm, 55 nm, 57 nm, 59 nm, 60 nm, 62 nm, 64 nm, 66 nm, 68 nm, 70 nm, 71 nm, 73 nm, 75 nm, 78 nm, 80 nm, 88 nm, 90 nm, 100 nm, 110 nm, 115 nm, 120 nm, 150 nm, 175 nm, 180 nm, 200 nm, 215 nm, 220 nm, 230 nm, 250 nm, 270 nm, 275 nm, 280 nm, 300 nm, or fall into a range composed of any two of these values, such as 40 nm-46 nm, 48 nm-53 nm, 55 nm-60 nm, 64 nm-70 nm, 40 nm-80 nm, 75 nm-80 nm, 50 nm-120 nm, 80 nm-100 nm, 80 nm-120 nm, 110 nm-150 nm, 110 nm-230 nm, 120 nm-150 nm, 150 nm-250 nm, or 250 nm-300 nm, and is selected according to actual needs, as long as the thickness of the grid line 31 is within the above range.

In the technical solution of the embodiments of the present application, when the thickness of the grid line 31 is within the above range, the solar cell 100 has a higher photoelectric conversion rate.

According to some embodiments of the present application, the present application provides a preparation method of the solar cell 100, including the following steps:

Provide the substrate 10.

Dispose the conductive layer 20 on the substrate 10, where the conductive layer 20 includes the plurality of conductive portions 21, with the first gap 21a between the conductive portions 21.

Dispose the grid line layer 30 on the conductive layer 20, where the grid line layer 30 includes the plurality of grid lines 31, and the grid lines 31 are disposed on the conductive portions 21.

Dispose the perovskite functional layer 40 on the conductive layer 20 and the grid line layer 30.

Dispose the electrode layer 50 on the perovskite functional layer 40, and form the second gap 41a penetrating the electrode layer 50 and the perovskite functional layer 40, where the perovskite functional layer 40 includes the plurality of functional portions 41, with the second gap 41a between the functional portions 41, each functional portion 41 is disposed on two adjacent conductive portions 21, each grid line 31 is located between the first gap 21a and the second gap 41a that are adjacent to each other, the electrode layer 50 includes the plurality of electrodes 51, with the second gap 41a between the electrodes 51, and the electrodes 51 are electrically connected to the grid lines 31.

In the technical solution of the embodiments of the present application, by disposing a grid line layer 30 between the conductive layer 20 and the perovskite functional layer 40, where the conductive layer 20 includes a plurality of conductive portions 21, the grid line layer 30 includes a plurality of grid lines 31 disposed on the conductive portions 21, the perovskite functional layer 40 includes a plurality of functional portions 41, the electrode layer 50 includes a plurality of electrodes 51, with a second gap 41a between each functional portion 41 and the electrode 51 disposed thereon and an adjacent functional portion 41 and the electrode 51 disposed thereon, each functional portion 41 is disposed on two adjacent conductive portions 21, and each grid line 31 is located between the first gap 21a and the second gap 41a that are adjacent to each other, series connection within the solar cell 100 is achieved through electrical connection between the electrodes 51 and the grid lines 31. Additionally, the second gap 41a between each functional portion 41 and the electrode 51 disposed thereon and an adjacent functional portion 41 and the electrode 51 disposed thereon allows for a single scribing step to penetrate the perovskite functional layer 40 and the electrode layer 50 during the preparation process, thereby simplifying the preparation process of the solar cell 100.

In some embodiments, the step of disposing the conductive layer 20 on the substrate 10 includes: performing a first scribing on a first prefabricated layer for forming the conductive layer 20 to form the plurality of conductive portions 21, with the first gap 21a between the conductive portions 21.

The material of the first prefabricated layer may be selected from fluorine-doped tin oxide (FTO) or indium tin oxide (ITO), but is not limited thereto. The scribing method for performing the first scribing on the first prefabricated layer for forming the conductive layer 20 may be laser scribing or chemical etching, but is not limited thereto.

In the technical solution of the embodiments of the present application, by performing the first scribing on the first prefabricated layer for forming the conductive layer 20, a plurality of conductive portions 21 are formed, with adjacent conductive portions 21 isolated by the first gap 21a.

In some embodiments, the steps of disposing the perovskite functional layer 40 on the conductive layer 20 and the grid line layer 30, disposing the electrode layer 50 on the perovskite functional layer 40, and forming the second gap 41a penetrating the electrode layer 50 and the perovskite functional layer 40 include: sequentially disposing a second prefabricated layer for forming the perovskite functional layer 40 and a third prefabricated layer for forming the electrode layer 50 on the conductive layer 20 and the grid line layer 30, and performing a second scribing on the second prefabricated layer and the third prefabricated layer to form the second gap 41a penetrating the third prefabricated layer and the second prefabricated layer.

The second prefabricated layer is a multilayer structure. The third prefabricated layer may be a single-layer structure or a multilayer structure. The third prefabricated layer may be a metal material or a transparent conductive material. The metal material may be metals such as copper, gold, silver, and their alloys. The transparent conductive material may be indium tin oxide, fluorine-doped tin oxide, or aluminum-doped zinc oxide. The scribing method for performing the second scribing on the second prefabricated layer and the third prefabricated layer may be laser scribing or chemical etching, but is not limited thereto.

In the technical solution of the embodiments of the present application, by performing the second scribing on the second prefabricated layer for forming the perovskite functional layer 40 and the third prefabricated layer for forming the electrode layer 50, the second gap 41a penetrating the third prefabricated layer and the second prefabricated layer is formed, allowing for a single scribing step to penetrate the perovskite functional layer 40 and the electrode layer 50 during the preparation process, thereby simplifying the preparation process of the solar cell 100.

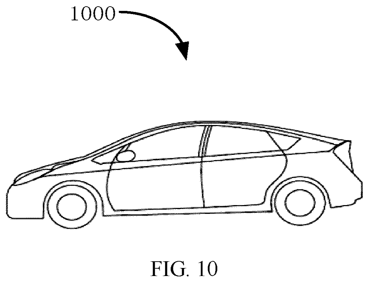

Referring to FIG. 10, the present application also provides an electric apparatus 1000, including the solar cell 100 as described above or a solar cell 100 prepared by the preparation method of the solar cell 100 as described above.

In the present application, the solar cell 100 serves as a power source for the electric apparatus 1000 to supply power thereto; alternatively, the solar cell 100 may serve as an energy storage unit of the electric apparatus 1000. As an example, the electric apparatus 1000 may be a lighting element, a display element, or an automobile.

The following further describes the features and performance of the present application in detail with reference to examples.

### Example 1:

This example provides a preparation method of a solar cell, including the following steps:
A substrate was provided, where the substrate included a first region, a second region, and a third region.

The substrate was made of glass with a thickness of 2.2 mm.

A conductive layer was disposed on the substrate, where the conductive layer included a plurality of conductive portions, with a first gap between the conductive portions, and the conductive layer was located in the second region.

The conductive layer was made of FTO with a thickness of 350 nm; and the width of the first gap was 50 µm.

A grid line layer, a perovskite functional layer, and an electrode layer were sequentially disposed on the conductive layer.

The grid line layer was made of copper; and the perovskite functional layer included a hole transport layer, a perovskite layer, and an electron transport layer, where the hole transport layer was made of nickel oxide with a thickness of 10 nm-15 nm; the perovskite layer was made of Cs_{0.05}FA_{0.95}PbI₃ doped with methylamine chloride (MACl) with a thickness of 650 nm-680 nm, where the concentration of methylamine chloride was 20% of the perovskite precursor concentration, and the perovskite precursor concentration was 1.55 mol/L; the electron transport layer was made of C₆₀ with a thickness of 15 nm-30 nm; and the electrode layer was made of copper with a thickness of 100 nm.

The grid line body was disposed on the conductive portion, the first extension portion was located in the first region, the second extension portion was located in the third region, a second gap was provided between the functional portions of the perovskite functional layer and between the electrodes of the electrode layer, the width of the second gap was 100 µm, each grid line was located between the first gap and the second gap that are adjacent to each other, the functional portion covered the grid line body, the first extension portion and the second extension portion were exposed from the functional portion, the diffusion portion of the electrode was disposed on the functional portion, the first electrical connection portion was disposed on the first extension portion or disposed on the first extension portion and the substrate, the second electrical connection portion was disposed on the second extension portion or disposed on the second extension portion and the substrate, the first electrical connection portion was electrically connected to the first extension portion, and the second electrical connection portion was electrically connected to the second extension portion.

The conductive layer of the solar cell provided in Example 1 was located in the second region, the grid line body was disposed on the conductive portion, the first extension portion was located in the first region, the second extension portion was located in the third region, and the first extension portion and the second extension portion were exposed from the functional portion.
Example 2:

A substrate was provided, where the substrate included a first region, a second region, and a third region.

The substrate was made of glass with a thickness of 2.2 mm.

A conductive layer was disposed on the substrate, where the conductive layer included a plurality of conductive portions, with a first gap between the conductive portions, the conductive layer was disposed in the second region and further disposed in the first region and/or the third region, the conductive layer in the first region and the third region was insulated from the conductive layer in the second region, and the conductive layer in the first region and the third region included a plurality of conductive branches, where the conductive branches corresponded to the conductive portions, and the conductive branches were insulated from each other.

The conductive layer was made of FTO with a thickness of 350 nm; and the width of the first gap was 50 µm.

A grid line layer, a perovskite functional layer, and an electrode layer were sequentially disposed on the conductive layer.
The grid line layer was made of copper; and the perovskite functional layer included a hole transport layer, a perovskite layer, and an electron transport layer, where the hole transport layer was made of nickel oxide with a thickness of 10 nm-15 nm; the perovskite layer was made of Cs_{0.05}FA_{0.95}PbI₃ doped with methylamine chloride (MACl) with a thickness of 650 nm-680 nm, where the concentration of methylamine chloride was 20% of the perovskite precursor concentration, and the perovskite precursor concentration was 1.55 mol/L; the electron transport layer was made of C₆₀ with a thickness of 15 nm-30 nm; and the electrode layer was made of copper with a thickness of 100 nm;
The grid line body was disposed on the conductive portion, the first extension portion was located in the first region, the second extension portion was located in the third region, the first extension portion and the second extension portion were disposed on the conductive branches, a second gap was provided between the functional portions of the perovskite functional layer and between the electrodes of the electrode layer, the width of the second gap was 100 µm, each grid line was located between the first gap and the second gap that are adjacent to each other, the functional portion covered the grid line body, the first extension portion and the second extension portion were exposed from the functional portion, the diffusion portion of the electrode was disposed on the functional portion, the first electrical connection portion was disposed on the first extension portion and/or the conductive branch where the first extension portion was located, the second electrical connection portion was disposed on the second extension portion and/or the conductive branch where the second extension portion was located, the first electrical connection portion was electrically connected to the first extension portion, and the second electrical connection portion was electrically connected to the second extension portion.

The conductive layer of the solar cell provided in Example 2 was located in the second region, the grid line body was disposed on the conductive portions and further disposed in the first region and/or the third region, the conductive layer in the first region and the third region was insulated from the conductive layer in the second region, and the conductive layer in the first region and the third region included a plurality of conductive branches, where the conductive branches corresponded to the conductive portions, the conductive branches were insulated from each other, and the first extension portion and the second extension portion were disposed on the conductive branches.

### Comparative example:

The comparative example provides a preparation method of the solar cell, including the following steps:
The substrate was provided.

The substrate was made of glass with a thickness of 2.2 mm.

The conductive layer was disposed on the substrate, where the conductive layer included a plurality of conductive portions, with a first gap between the conductive portions.

The conductive layer was made of FTO with a thickness of 350 nm; and the width of the first gap was 50 µm.

A perovskite functional layer and an electrode layer were sequentially disposed on the conductive layer.

The grid line layer was made of copper; and the perovskite functional layer included a hole transport layer, a perovskite layer, and an electron transport layer, where the hole transport layer was made of nickel oxide with a thickness of 10 nm-15 nm; the perovskite layer was made of Cs_{0.05}FA_{0.95}PbI₃ doped with methylamine chloride (MACl) with a thickness of 650 nm-680 nm, where the concentration of methylamine chloride was 20% of the perovskite precursor concentration, and the perovskite precursor concentration was 1.55 mol/L; the electron transport layer was made of C₆₀ with a thickness of 15 nm-30 nm; and the electrode layer was made of copper with a thickness of 100 nm.

The perovskite functional layer had channels, where the channels extended from a side of the perovskite functional layer facing the electrode layer to a side of the perovskite functional layer facing the conductive layer, the width of the channels was 100 µm, and a conductive material was disposed within the channels to form a current path in the solar cell.

The perovskite functional layer and the electrode layer had second gaps communicating with each other, the width of the second gap was 100 µm, the second gap extended from a side of the electrode layer facing away from the perovskite functional layer to a side of the perovskite functional layer facing the conductive layer, the channels were located between the first gap and the second gap, the second gap divided the perovskite functional layer and the electrode layer into a plurality of cell unit components, and the electrode layer in one cell unit component formed a series structure with the conductive layer in an adjacent cell unit component in the solar cell.

The perovskite functional layer of the solar cell provided in the comparative example had a channel, where the channel was located between the first gap and the second gap.

The solar cells of Examples 1 and 2 and the comparative example were tested for photoelectric conversion efficiency, with the test method as follows, and the test results are shown in Table 1:
1. Photoelectric conversion efficiency test:
   Under standard simulated sunlight (with AM 1.5G, 100 mW/cm²) irradiation, the cell performance was tested to obtain the I-V curve. Based on the I-V curve and the data fed back by the test equipment, the short-circuit current Jsc (in the unit of mA/cm²), open-circuit voltage Voc (in the unit of V), maximum light output current Jmpp (in the unit of mA), and maximum light output voltage Vmpp (in the unit of V) were obtained. The fill factor FF was calculated according to the formula FF = Jsc × Voc / (Jmpp × Vmpp), in the unit of %. The photoelectric conversion efficiency PCE was calculated according to the formula PCE = Jsc × Voc × FF / Pw, in the unit of %, where Pw represents the input power, in the unit of mW.

**Table 1: Performance parameters of solar cells in Examples 1 and 2 and Comparative example**

| Sample | Grid line thickness (nm) | Photoelectric conversion efficiency (%) |
|---|---|---|
| Example 1-Sample 1 | 0 | 0 |
| Example 1-Sample 2 | 10 | 16.1 |
| Example 1-Sample 3 | 20 | 16.4 |
| Example 1-Sample 4 | 40 | 17.8 |
| Example 1-Sample 5 | 60 | 18.4 |
| Example 1-Sample 6 | 80 | 19.1 |
| Example 1-Sample 7 | 120 | 19.3 |
| Example 1-Sample 8 | 150 | 18.8 |
| Example 1-Sample 9 | 250 | 18.5 |
| Example 1-Sample 10 | 300 | 18.1 |
| Example 2-Sample 1 | 0 | 0 |
| Example 2-Sample 2 | 10 | 15.7 |
| Example 2-Sample 3 | 20 | 16.2 |
| Example 2-Sample 4 | 40 | 17.5 |
| Example 2-Sample 5 | 60 | 17.9 |
| Example 2-Sample 6 | 80 | 18.6 |
| Example 2-Sample 7 | 120 | 18.7 |
| Example 2-Sample 8 | 150 | 18.4 |
| Example 2-Sample 9 | 250 | 18.2 |
| Example 2-Sample 10 | 300 | 17.9 |
| Comparative example | 0 | 16.5 |

The test results in Table 1 for Examples 1 and 2 and the comparative example indicate that the photoelectric conversion efficiency of the solar cell provided by the present application increases with the thickness of the grid line. When the grid line thickness of the solar cell provided by the present application is greater than or equal to 40 nm, optionally 40-300 nm, the photoelectric conversion efficiency of the solar cell provided by the present application is higher than that of the comparative example. At this point, the solar cell provided by the present application exhibits high stability.

Further, through comparison between Examples 1 and 2, the photoelectric conversion efficiency of the solar cell in Example 1 is higher than that of the solar cell in Example 2.

## Claims

1. A solar cell comprising:
a substrate;
a conductive layer disposed on the substrate, wherein the conductive layer comprises a plurality of conductive portions, with a first gap between the conductive portions;
a grid line layer disposed on the conductive layer, wherein the grid line layer comprises a plurality of grid lines, and the grid lines are disposed on the conductive portions;
a perovskite functional layer disposed on the conductive layer and the grid line layer, wherein the perovskite functional layer comprises a plurality of functional portions, with a second gap between the functional portions, each functional portion is disposed on two adjacent conductive portions, and each grid line is located between the first gap and the second gap that are adjacent to each other; and
an electrode layer disposed on the perovskite functional layer, wherein the electrode layer comprises a plurality of electrodes, with the second gap between the electrodes, and the electrodes are electrically connected to the grid lines.

2. The solar cell according to claim 1, wherein the grid line comprises a grid line body, an end of the grid line body is provided with a first extension portion and/or a second extension portion, the functional portion covers the grid line body, the first extension portion and/or the second extension portion is exposed from the functional portion, the electrode comprises a diffusion portion, an end of the diffusion portion is provided with a first electrical connection portion and/or a second electrical connection portion, the diffusion portion is disposed on the functional portion, the first electrical connection portion is electrically connected to the first extension portion, and/or the second electrical connection portion is electrically connected to the second extension portion.

3. The solar cell according to claim 2, wherein the substrate comprises a first region, a second region, and a third region, the second region is located between the first region and the third region, and the conductive layer is disposed in the second region.

4. The solar cell according to claim 3, wherein the first extension portion and the first electrical connection portion are located in the first region, the first extension portion is disposed on the substrate, and the first electrical connection portion is disposed on the first extension portion or disposed on the first extension portion and the substrate.

5. The solar cell according to claim 3 or 4, wherein the second extension portion and the second electrical connection portion are located in the third region, the second extension portion is disposed on the substrate, and the second electrical connection portion is disposed on the second extension portion or disposed on the second extension portion and the substrate.

6. The solar cell according to claim 2, wherein the substrate comprises a first region, a second region, and a third region, the second region is located between the first region and the third region, the conductive layer is disposed in the second region and further disposed in the first region and/or the third region, the conductive layer in the first region and the third region is insulated from the conductive layer in the second region, the conductive layer in the first region and the third region comprises a plurality of conductive branches, the conductive branches correspond to the conductive portions, and the conductive branches are insulated from each other.

7. The solar cell according to claim 6, wherein the first extension portion and the first electrical connection portion are located in the first region, the first extension portion is disposed on one of the conductive branches, and the first electrical connection portion is disposed on the first extension portion and/or the conductive branch where the first extension portion is located.

8. The solar cell according to claim 6 or 7, wherein the second extension portion and the second electrical connection portion are located in the third region, the second extension portion is disposed on one of the conductive branches, and the second electrical connection portion is disposed on the second extension portion and/or the conductive branch where the second extension portion is located.

9. The solar cell according to any one of claims 1 to 8, wherein a thickness of the grid line is greater than or equal to 40 nm, optionally 40-80 nm.

10. A preparation method of the solar cell according to any one of claims 1 to 9, comprising:
providing the substrate;
disposing the conductive layer on the substrate, wherein the conductive layer comprises the plurality of conductive portions, with the first gap between the conductive portions;
disposing the grid line layer on the conductive layer, wherein the grid line layer comprises the plurality of grid lines, and the grid lines are disposed on the conductive portions;
disposing the perovskite functional layer on the conductive layer and the grid line layer; and
disposing the electrode layer on the perovskite functional layer, and forming the second gap penetrating the electrode layer and the perovskite functional layer, wherein the perovskite functional layer comprises the plurality of functional portions, with the second gap between the functional portions, each functional portion is disposed on two adjacent conductive portions, each grid line is located between the first gap and the second gap that are adjacent to each other, the electrode layer comprises the plurality of electrodes, with the second gap between the electrodes, and the electrodes are electrically connected to the grid lines.

11. The preparation method of the solar cell according to claim 10, wherein the step of disposing the conductive layer on the substrate comprises:
performing a first scribing on a first prefabricated layer for forming the conductive layer to form the plurality of conductive portions, with the first gap between the conductive portions.

12. The preparation method of the solar cell according to claim 11, wherein the steps of disposing the perovskite functional layer on the conductive layer and the grid line layer, disposing the electrode layer on the perovskite functional layer, and forming the second gap penetrating the electrode layer and the perovskite functional layer comprise:
sequentially disposing a second prefabricated layer for forming the perovskite functional layer and a third prefabricated layer for forming the electrode layer on the conductive layer and the grid line layer, and performing a second scribing on the second prefabricated layer and the third prefabricated layer to form the second gap penetrating the third prefabricated layer and the second prefabricated layer.

13. An electric apparatus comprising the solar cell according to any one of claims 1 to 9 or a solar cell prepared by the preparation method according to any one of claims 10 to 12.
